Europäisches Patentamt

European Patent Office

Office européen des brevets

(19)

(11) Veröffentlichungsnummer: **0 126 969 B1**

(12) **EUROPÄISCHE PATENTSCHRIFT**

(45) Veröffentlichungstag der Patentschrift: **15.05.91**

(51) Int. Cl.5: **H01L 21/31**, H01L 21/28

(21) Anmeldenummer: **84104580.0**

(22) Anmeldetag: **24.04.84**

(54) **Verfahren zum Herstellen von Strukturen von aus Metallsiliziden bzw. Silizid-Polysilizium bestehenden Schichten für integrierte Halbleiterschaltungen durch reaktives Ionenätzen.**

(30) Priorität: **29.04.83 DE 3315719**

(43) Veröffentlichungstag der Anmeldung:
**05.12.84 Patentblatt 84/49**

(45) Bekanntmachung des Hinweises auf die
Patenterteilung:
**15.05.91 Patentblatt 91/20**

(84) Benannte Vertragsstaaten:
**CH DE FR GB IT LI**

(56) Entgegenhaltungen:
**EP-A- 0 094 528**
**GB-A- 2 098 931**

**JOURNAL OF THE ELECTROCHEMICAL SOCIETY, Band 131, Nr. 2, Februar 1984, Seiten 459-461, Manchester, New Hampshire, GB; R.W. LIGHT et al.: "Patterning of tantalum polycide films"**

**EXTENDED ABSTRACTS, Band 84, Nr. 2, 1984, Seiten 496-497, New Orleans, Louisiana, US; F.Y. ROBB: "Chlorine-based plasma etching of titanium silicide films"**

(73) Patentinhaber: **Siemens Aktiengesellschaft**
**Wittelsbacherplatz 2**
**W-8000 München 2(DE)**

(72) Erfinder: **Beinvogl, Willy, Dr. rer. nat.**
**Mallnitzer Strasse 16**
**W-8000 München 21(DE)**
Erfinder: **Hasler, Barbara**
**Engerstrasse 17**
**W-8035 Stockdorf(DE)**

## Beschreibung

Die vorliegende Patentanmeldung bezieht sich auf ein Verfahren zum Herstellen von Strukturen von aus Metallsiliziden bzw. Silizid-Polysilizium bestehenden Schichten auf integrierte Halbleiterschaltungen enthaltenden Siliziumsubstraten durch reaktives Ionenätzen unter Verwendung einer Fotolackmaske, bei dem in einem Parallel-Plattenreaktor als reaktives Gas ein Chlor enthaltendes Gasgemisch verwendet wird, wie es aus dem unter Artikel 54(3) EPü fallenden Dokument EP-A-0 094 528 bekannt ist.

Metallsilizide finden bei der Herstellung von hochintegrierten MOS-Schaltungen zunehmende Bedeutung. Eine der möglichen Anwendungen ist ihre Verwendung als niederohmiges Leitbahn- und Gatematerial in einem Poly-Silizium-Gate-Prozess. Das bewährte Polysilizium wird dabei im allgemeinen nicht durch das Silizid ersetzt, sondern ergänzt, und zwar in der Form, daß man über einer dotierten Polysiliziumschicht das Silizid aufbringt. Die Erzeugung feiner Strukturen in solchen Doppelschichten ist ein komplexes Ätzproblem, da bei der Herstellung von Schaltungen eine Reihe von Randbedingungen zu beachten sind. Diese Randbedingungen sind:

a) hohe Selektivität zu SiO$_2$ oder entsprechenden isolierenden Schichten (Schichtdickenverhältnis Polyzid: SiO$_2$ bis zu 50:1, sehr dünne SiO$_2$-Schichten unter Polyzid),
b) Anisotropie der Ätzung mit senkrechten Flanken, wichtig vor allem bei VLSI-Schaltungen,
c) Verwendung von Fotolack als Ätzmaske, was bei bestimmten Ätzgasen, zum Beispiel Tetrachlorkohlenstoff oftmals Probleme bereitet,
d) Kontakt Polyzid-Substrat ("buried"-Kontakt),
e) Erzielung einer guten Ätzgleichmäßigkeit (ist besonders wichtig wegen des sogenannten Kurzkanaleffektes), und
f) angepaßte Ätzzeiten, wobei einerseits hoher Durchsatz möglich ist, andererseits gute Kontrollierbarkeit des Prozesses gegeben ist.

Aus dem Stand der Technik ist bekannt, Strukturen von Metallsiliziden zu ätzen, wobei in fast allen bekannten Fällen Molybdän- und Wolframsilizide geätzt werden. Über die Ätzung von Tantalsilizidstrukturen, welches gegenüber Molybdän- und Wolframsiliziden wegen der besseren Temperaturstabilität bei hohen Temperaturen und der guten Hafteigenschaften auf Polysilizium erhebliche Vorteile hat, gibt es nur einen kurzen Hinweis in J. Vac. Sci. Technol. 17 (4) Juli/August 1980, Seiten 787/788, aus dem zu entnehmen ist, daß Titan-, Tantal-, Molybdän- und Wolfram-Silizide im Plasma in einer Tetrafluor-Kohlenstoff-Sauerstoff-Mischung zu ätzen sind. Dabei werden die Ätzungen teils im Tunnelreaktor, teils im Parallel-Plattenreaktor in anodischer Kopplung (Plasmaätzen) durchgeführt (siehe auch J. Vac. Sci. Technol. 18 (2), März 1981, Seite 346). Im Prinzip können diese Schichten auch naß geätzt werden, jedoch nur mit dem für Naßätzung üblichen Maßverlust. Es ist ein Charakteristikum von Doppelschichten, daß beim Strukturieren eine Vielfalt von Flankenformen auftreten kann, von denen nur wenige bei der Schaltungsherstellung verwendet werden können.

Aus der europäischen Patentanmeldung 0 015 403 sind mehrere Verfahren zum reaktiven Ionenätzen von Polysilizium zu entnehmen, wobei von Gasmischungen bestehend aus Schwefelhexafluorid (SF$_6$), Chlor (Cl$_2$) und einem Inertgas ausgegangen wird. Bei diesen Verfahren wird aber nur Silizium selektiv geätzt, wobei eine sehr gute Selektivität in Gegenwart von SiO$_2$ und Siliziumnitrid erzielt wird. Daneben wird auch, bedingt durch das reaktive Ionenätzen (die zu ätzenden Substrate werden auf die HF-führende Elektrode gelegt) eine gerichtete Ätzung durchgeführt, so daß die erzeugten Vertiefungen senkrechte Seitenwände haben und die Ätzmaske über den Rand der geätzten Vertiefungen nicht hinausragt.

Ein Verfahren der eingangs genannten Art ist für die Molybdänätzung aus dem Japanese Journal of Appl. Physics, Vol. 21, No. 1, Januar 1982, Seiten 168 bis 172 bekannt. Bei diesem Verfahren wird ein aus Tetrachlorkohlenstoff (CCl$_4$) und Sauerstoff bestehendes Gasgemisch als Ätzgas verwendet und der Parallelplattenreaktor in kathodischer Kopplung betrieben.

Die Aufgabe, die der Erfindung zugrundeliegt, besteht in der Angabe eines anisotropen Ätzprozesses für Metallsilizid-und Metallsilizid-Polysilizium-Doppelschichtstrukturen, bei dem sowohl eine hohe Selektivität zu SiO$_2$, als auch die für die Fertigung von VLSI-Schaltungen erforderliche strenge Anisotropie gewährleistet ist. Außerdem sollen die Ätzzeiten so einstellbar sein, daß einerseits ein hoher Durchsatz möglich ist, andererseits der Prozeß gut steuerbar ist.

Diese Aufgabe wird bei einem Verfahren der eingangs genannten Art dadurch gelöst, daß als reaktives Gas Chlorgas mit einer Beimischung einer stark reduzierenden Komponente nämlich Bortrichlorid, verwendet wird. In einer Weiterbildung des Erfindungsgedankens ist vorgesehen, Bortrichlorid (BCl$_3$) dem Chlorgas so beizumischen, daß das Verhältnis des Bortrichloridanteils zum Chloranteil der Gasmischung kleiner als 1:2 ist.

Das Verfahren nach der Lehre der Erfindung kann auf alle Polyzide angewandt werden, deren Silizid im Chlor ätzbare Metalle enthält (zum Beispiel Titan-, Molybdän-, Tantal-Silizid). Vorzugsweise wird das erfindungsgemäße Verfahren zur Ätzung von aus Tantalsilizid und Polysilizium bestehenden Doppelschichtstrukturen verwendet. Das Verfahren ist aber auch auf Silizid-Einfachschichten anwendbar. Selbstverständlich sind auch reine Polysiliziumschichten mit dem beschriebenen Verfahren ätzbar.

Die Vorteile des erfindungsgemäßen Verfahrens gegenüber den bekannten Verfahren liegen insbesondere darin, daß die Verwendung von schädlichen Tetrachlorkohlenstoff ($CCl_4$) umgangen werden kann. $CCl_4$ ist cancerogen und kann Phosgen bilden; deshalb ist für den Umgang mit $CCl_4$ besondere Vorsicht geboten. Der Dampfdruck von $CCl_4$ liegt bei Raumtemperatur unter 100 Pa (760 mTorr). Um eine ausreichende Verdunstung zu erreichen, muß der Vorratsbehälter erwärmt werden, was zur Kondensation in den Ventilen führen kann. Die Verwendung eines nur Chlor enthaltenden Gasgemisches, wie es bei der Erfindung vorliegt, hat auch Vorteile gegenüber den Verfahren, die Fluor und Chlor in Folge benutzen. Es ist eine häufige Erfahrung beim Trockenätzen, daß sich in diesem Falle "memory-Effekte" zeigen, was eine reproduzierbare Prozeßführung erschwert. Unter "memory-Effekt" versteht man die Beeinflussung eines Prozeßschritts durch einen vorhergehenden, etwa durch unvollständige Entfernung von chemischen Verbindungen aus dem Reaktor.

Andere Ausgestaltungen der Erfindung ergeben sich aus den Unteransprüchen.

Weitere Einzelheiten des erfindungsgemäßen Verfahrens werden im folgenden anhand von Ausführungsbeispielen und der Figuren 1 bis 3 noch näher erläutert. Dabei zeigen

die Figuren 1 und 2
die Abhängigkeit des Ätzprofils von der Gaszusammensetzung und
die Figur 3
eine durch das Verfahren nach der Lehre der Erfindung hergestellte Polyzidstruktur mit "buried"-Kontakt.

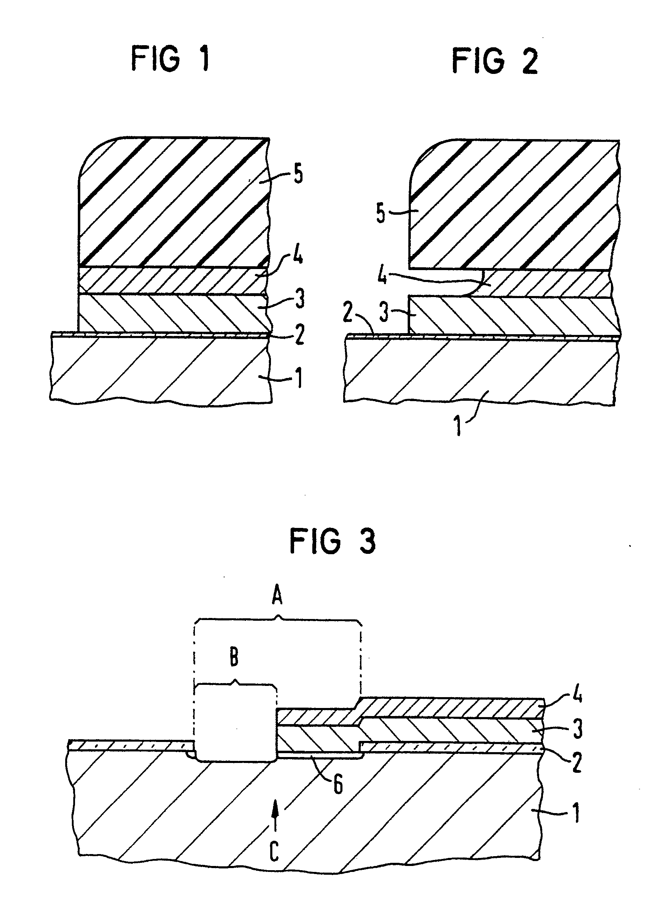

Wie aus den Figuren 1 und 2 zu entnehmen ist, ist die erfindungsgemäße Gaszusammensetzung entscheidend für die Qualität der Ätzung. Mit reinem Chlorgas ist es nicht möglich, Tantalsilizid zu ätzen; die Ursache dafür sind wahrscheinlich ätzresistente Oxidschichten an der Oberfläche des Silizids. Durch die Beimengung einer stark reduzierenden Komponente zum Chlorgas wie Bortrichlorid, welches im Plasma zu $BCl_x$, wobei $x < 3$ ist, zerlegt wird, wird ein Ätzabtrag erzielt. Der Bortrichloridanteil muß jedoch klein sein, da sonst das Silizid unterätzt wird. Figur 1 zeigt ein Ätzprofil, welches mit der Gaszusammensetzung $BCl_3:Cl_2$ = 2:5 erzielt wurde und Figur 2 ein Ätzprofil, welches mit der Gaszusammensetzung $BCl_3:Cl_2$ = 5:1 erhalten wurde. Mit dem Bezugszeichen 1 ist das Siliziumsubstrat, mit 2 eine 40 nm dicke $SiO_2$-Schicht, mit 3 eine 300 nm dicke $n^+$-dotierte Polysiliziumschicht, mit 4 eine 200 nm dicke Tantalsilizidschicht und mit 5 eine aus einem positiv arbeitenden Fotolack bestehende Maske bezeichnet.

Es hat sich als besonders vorteilhaft erwiesen, wenn die reaktiven Gase mit einem Edelgas, zum Beispiel Helium, verdünnt werden. Wird eine besonders hohe Selektivität zu $SiO_2$ ($\gg$ 30:1) gewünscht, mischt man dem $Cl_2$ nur am Anfang der Ätzung $BCl_3$ bei und beendet den Ätzvorgang in reinem $Cl_2$.

Der Gasdruck im Reaktor muß genügend niedrig und die bias-Spannung der HF-führenden Elektrode hoch genug sein, um ein strikt anisotropes Ätzen zu ermöglichen (Werte sind in den nachfolgenden Ausführungsbeispielen angegeben).

Ein Vorteil des Verfahrens ist es, daß Fotolack (zum Beispiel Shipley-Positivlack) als Ätzmaske verwendet werden kann, so daß keine zusätzlichen Hilfsschichten nötig sind.

Figur 3: Es gelten die gleichen Bezugszeichen wie bei Figur 1 und 2. Ein besonderer Vorteil des Verfahrens ist es, daß ein $Cl_2$-Plasma eine stark dotierungsabhängige Ätzrate aufweist, für n-dotiertes Polysilizium 3 ($n^+$-Polysilizium ätzt unter den Bedingungen des Ausführungsbeispiels etwa 6 mal schneller als undotiertes Silizium). Dies ist von praktischer Bedeutung im sogenannten "buried"-Kontakt. Wird das Polysilizium 3 durch Diffusion dotiert, so wird auch dabei das Substrat 1 im Bereich A an der Oberfläche (6) dotiert. Bei geeigneter Prozeßführung kann die Eindringtiefe jedoch gering gehalten werden (0,1 bis 0,2 $\mu$m). Die unvermeidliche Substratanätzung im Bereich B während des Strukturierens von Polyzid 3,4 ist wegen der genannten Dotierungsabhängigkeit der Silizium-Ätzrate gering (vergleichbar mit der Eindringtiefe des Dotierstoffes). Damit kann man das Entstehen einer hohen Stufe (siehe Pfeil C) und eine eventuelle Verschlechterung des elektrischen Übergangswiderstandes im "buried"-Kontakt sowie topographische Probleme bei nachfolgenden Prozeßschritten vermeiden.

Ausführungsbeispiele:

1. Reaktives Ionenätzen im Einstufenprozeß.

Gaszusammensetzung $Cl_2/BCl_3/He$ = 5/2/50
Leistung P = 0,15 $W/cm^2$
Druck p = 1,5 Pa ( = 10 m Torr)
Ätzprofil: streng anisotrop
Selektivität zu $SiO_2$ = 15:1

2. Reaktives Ionenätzen im Zweistufenprozeß:

Die erste Stufe wird durchgeführt wie bei 1. beschrieben, ungefähr 1 Minute lang.

In der zweiten Stufe wird ohne BCl₃ geätzt; sonst sind die Bedingungen wie bei 1. Dadurch erhöht sich die Selektivität zu SiO₂ auf 30:1 bei einer Gesamtätzzeit von 6 Minuten für eine 100 mm Siliziumscheibe.

**Ansprüche**

1. Verfahren zum Herstellen von Strukturen von aus Metallsiliziden bzw. Silizid-Polysilizium (4,3) bestehenden Schichten auf integrierte Halbleiterschaltungen enthaltenden Siliziumsubstraten (1) durch reaktives Ionenätzen unter Verwendung einer Fotolackmaske (5), bei dem in einem Parallel-Plattenreaktor als reaktives Gas Chlorgas und als stark reduzierende Komponente Bortrichlorid (BCl₃) verwendet wird.

2. Verfahren nach Anspruch 1, **dadurch gekennzeichnet,** daß die Gaszusammensetzung so gewählt wird, daß das Verhältnis des Bortrichloridanteils zum Chloranteil in der Gasmischung kleiner als 1:2 ist.

3. Verfahren nach Anspruch 1 oder 2, **dadurch gekennzeichnet,** daß als Trägergas ein Edelgas, vorzugsweise Helium, verwendet wird.

4. Verfahren nach Anspruch 3, **dadurch gekennzeichnet,** daß das Mischungsverhältnis Chlor/Bortrichlorid/Trägergas auf 5/2/50 eingestellt wird.

5. Verfahren nach Anspruch 1 bis 4, **dadurch gekennzeichnet,** daß eine aus Tantalsilizid (4) (TaSi₂) und Polysilizium (3) bestehende Doppelschicht verwendet wird.

6. Verfahren nach Anspruch 5, **dadurch gekennzeichnet,** daß die Doppelschicht aus einer 200 nm dicken Tantalsilizidschicht (4) und aus einer 300 nm dicken n⁺-dotierten Polysiliziumschicht (3) besteht.

7. Verfahren nach Anspruch 1 bis 6, **dadurch gekennzeichnet,** daß zur Erhöhung der Selektivität zu SiO₂ der Ätzprozeß in zwei Stufen durchgeführt wird, wobei zunächst etwa ein Fünftel der Ätzzeit mit der Bortrichlorid-Beimischung geätzt wird und anschließend mit einem reinen Chlor-Edelgas-Gasgemisch geätzt wird.

8. Verfahren nach Anspruch 1 bis 7, **dadurch gekennzeichnet,** daß der Gasdruck im Reaktor auf einen Bereich von 1,5 Pa, und die Leistung auf 0,15 W/cm² eingestellt wird.

**Claims**

1. Process for producing structures of layers composed of metal silicides or silicide/polysilicon (4,3) on silicon substrates (1) containing integrated semiconductor circuits by reactive ion etching using a photoresist mask (5), in which chlorine gas is used as reactive gas and boron trichloride (BCl₃) as strongly reducing component in a parallel plate reactor.

2. Process according to Claim 1, characterised in that the gas composition is so chosen that the ratio of the boron trichloride component to the chlorine component in the gas mixture is less than 1:2.

3. Process according to Claim 1 or 2, characterised in that a noble gas, preferably helium, is used as carrier gas.

4. Process according to Claim 3, characterised in that the chlorine/boron trichlorine/carrier gas mixing ratio is adjusted to 5/2/50.

5. Process according to Claims 1 to 4, characterised in that a double layer composed of tantalum silicide (4) (TaSi₂) and polysilicon (3) is used.

6. Process according to Claim 5, characterised in that the double layer is composed of a 200 nm thick tantalum silicide layer (4) and of a 300 nm thick n⁺-doped polysilicon layer (3).

7. Process according to Claims 1 to 6, characterised in that, to increase the selectivity for SiO₂, the etching process is carried out in two steps in which etching is first carried out with the boron trichloride admixture for about a fifth of the etching time and etching is then carried out with a pure chlorine/noble gas gas mixture.

8. Process according to Claims 1 to 7, characterised in that the gas pressure in the reactor is adjusted to a range of 1.5 Pa and the power to 0.15 W/cm².

**Revendications**

1. Procédé pour fabriquer des substrats en silicium (1), qui contiennent des structures formées de couches constituées par des siliciures métalliques et en siliciure-polysilicium (4,3) sur des circuits intégrés à semiconducteurs, par corrosion ionique réactive moyennant l'utilisation d'un masque en laque photosensible (5), et selon lequel, dans un réacteur à plaques parallèles, on utilise comme gaz réactif du chlore gazeux et, comme composant fortement réducteur, du trichlorure de bore ($BCl_3$).

2. Procédé suivant la revendication 1, caractérisé par le fait qu'on choisit la composition du gaz de manière que le rapport du composant formé par le trichlorure de bore au composant formé par le chlore dans le mélange gazeux est inférieur à 1:2.

3. Procédé suivant la revendication 1 ou 2, caractérisé par le fait qu'on utilise comme gaz porteur un gaz rare, de préférence de l'hélium.

4. Procédé suivant la revendication 3, caractérisé par le fait qu'on règle les rapports du mélange chlore/ trichlorure de bore/gaz porteur à 5/2/50.

5. Procédé suivant les revendications 1 à 4, caractérisé par le fait qu'on utilise une couche double constituée de siliciure de tantale (4) ($TaSi_2$) et de polysilicium (3).

6. Procédé suivant la revendication 5, caractérisé par le fait que la couche double est constituée par une couche de siliciure de tantale (4) possédant une épaisseur de 200 nm et une couche de polysilicium (3) dopé du type $N^+$, possédant une épaisseur de 300 nm.

7. Procédé suivant les revendications 1 à 6, caractérisé par le fait que pour accroître la sélectivité vis-à-vis du $SiO_2$, on met en oeuvre l'opération de corrosion en deux étapes, auquel cas on réalise tout d'abord une corrosion pendant une durée égale approximativement au cinquième de la durée de corrosion, en utilisant l'additif formé de trichlorure de bore, et on réalise ensuite la corrosion en utilisant un pur mélange gazeux formé de chlore et d'un gaz rare.

8. Procédé suivant les revendications 1 à 7, caractérisé par le fait qu'on règle la pression du gaz dans le réacteur au voisinage de 1,5 Pa et la puissance à 0,15 W/cm².

# FIG 1

# FIG 2

# FIG 3